# EUROPÄISCHE PATENTSCHRIFT

(11) **EP 3 119 852 B1**
(45) Veröffentlichungstag und Bekanntmachung des Hinweises auf die Patenterteilung: **19.09.2018**
(21) Anmeldenummer: 15710101.5
(22) Anmeldetag: 17.02.2015
(51) Int. Cl.: C09K 11/78, H05B 33/18, H01L 33/50

(54) **SAMARIUM-DOTIERTE TERBIUMMOLYBDATE**
SAMARIUM-DOPED TERBIUMMOLYBDATE
MOLYBDATE DE TERBIUM DOPÉ AU SAMARIUM

(30) Priorität: 18.03.2014 DE 102014003848
(43) Veröffentlichungstag der Anmeldung: 25.01.2017
(73) Patentinhaber: Merck Patent GmbH, 64293 Darmstadt (DE)
(72) Erfinder: PETRY, Ralf, 64347 Griesheim (DE); JUESTEL, Thomas, 58455 Witten (DE); BAUR, Florian, 48165 Muenster (DE)
(86) Internationale Anmeldenummer: PCT/EP2015/000345
(87) Internationale Veröffentlichungsnummer: WO 2015/139806

(56) Entgegenhaltungen:
- CN-A- 103 275 713
- RU-C1- 2 456 712
- US-A- 3 437 432
- XUAN YA-WEN ET AL: "Synthesis and Fluorescence Properties of Tb3, Eu3+ Codoped Strontium Molybdate Phosphors", JOURNAL OF SYNTHETIC CRYSTALS, EDITORIAL BOARD OF JOURNAL OF SYNTHETIC CRYSTALS, CHINA, Bd. 42, Nr. 7, 1. Juli 2013 (2013-07-01), Seite 1402, XP008176471, ISSN: 1000-985X
- E. G. PONYATOVSKII: "Amorphization of rare-earth molybdates under high pressure", JETP LETTERS, Bd. 61, Nr. 3, 10. Februar 1995 (1995-02-10), Seiten 222-226, XP055193687,
- B. K. PONOMAREV ET AL: "Irreversible alterations of ferroelectric domain structure in paramagnetic rare earth molybdates induced by a magnetic field", JOURNAL OF APPLIED PHYSICS, Bd. 75, Nr. 12, 1. Januar 1994 (1994-01-01), Seite 8004, XP055193671, ISSN: 0021-8979, DOI: 10.1063/1.356538
- OUWERKERK MARTIN ET AL: "Some observations on the luminescence of rare-earth molybdates with .beta.'-Gd2(MoO4)3 structure", JOURNAL OF THE CHEMICAL SOCIETY, FARADAY TRANSACTIONS 2, CHEMICAL SOCIETY. LETCHWORTH, GB, Bd. 78, 1. Januar 1982 (1982-01-01), Seiten 603-611, XP009103240, DOI: 10.1039/F29827800603
- F. BAUR ET AL: "Photoluminescence and energy transfer rates and efficiencies in Eu 3+ activated Tb 2 Mo 3 O 12", JOURNAL OF MATERIALS CHEMISTRY C, Bd. 3, Nr. 9, 30. Dezember 2014 (2014-12-30), Seiten 2054-2064, XP055193684, ISSN: 2050-7526, DOI: 10.1039/C4TC02588A

## Beschreibung

Die vorliegende Erfindung betrifft Samarium-dotierte Terbiummolybdate, ein Herstellungsverfahren für diese Verbindungen, sowie die Verwendung der erfindungsgemäßen Samariumdotierten Terbiummolybdate als Konversionsleuchtstoffe. Ein weiterer Gegenstand der vorliegenden Erfindung betrifft eine lichtemittierende Vorrichtung, die ein erfindungsgemäßes Samariumdotiertes Terbiummolybdat enthält.

Anorganische fluoreszente Pulver, die im blauen und/oder UV-Spektralbereich anregbar sind, haben eine große Bedeutung als Konversionsleuchtstoffe für phosphorkonvertierte (phosphor converted) LEDs, kurz pc-LEDs. Mittlerweile sind viele Konversionsleuchtstoffsysteme bekannt, wie beispielsweise Erdalkaliorthosilikate, Thiogallate, Granate, Nitride und Oxynitride, die jeweils mit Ce³⁺ oder Eu²⁺ dotiert sind. Für die Realisierung warmweißer Lichtquellen mit Farbtemperaturen < 4000 K auf das Basis von blau- oder UV-A emittierenden (In,Ga)N LEDs werden neben den gelb- oder grün emittierenden Granaten bzw. ortho-Silikaten rot-emittierende Leuchtstoffe mit Emissionswellenlängen über 600 nm benötigt, die ausreichend stark bei der entsprechenden Wellenlänge der Primärstrahlung (370 - 480 nm) emittieren. Gleichzeitig muss die Stabilität dieser Leuchtstoffe ähnlich hoch wie die der Granate oder ortho-Silikate sein, damit es nicht im Laufe der Lebensdauer der Festkörperlichtquelle zu einer unerwünschten Farbpunktverschiebung kommt.

Zu diesem Zweck wurden in den vergangenen 20 Jahren eine Reihe von Leuchtstoffen vorgeschlagen bzw. entwickelt, die diese Anforderungen erfüllen. Die bisher verwendeten Leuchtstoffe, nämlich (Ca,Sr)S:Eu, (Ca,Sr)AlSiN₃:Eu und (Ca,Sr,Ba)₂Si₅N₈:Eu basieren alle auf dem Aktivator Eu²⁺, der sich sowohl durch ein breites Absorptionsspektrum als auch durch eine breite Emissionsbande auszeichnet. Der wesentliche Nachteil dieser Eu²⁺ aktivierten Materialien, ist deren relativ hohe Empfindlichkeit bzgl. einer Photodegradation, da das divalente Eu²⁺ zur Photoionisation, vor allem in Wirtsmaterialien mit relativ geringer Bandlücke, neigt.

Ein weiterer Nachteil ist die recht hohe Halbwertsbreite der Eu²⁺ Emissionsbande, was sich in einem moderaten Lumenäquivalent (< 200 lm/W) äußert, wenn der Farbpunkt im tiefroten Spektralbereich liegt. Diese Beobachtung trifft vor allem für die Leuchtstoffe (Ca,Sr)S:Eu und (Ca,Sr)AlSiN₃:Eu zu.

Darum ist es wünschenswert, einen rot-emittierenden Leuchtstoff zu entwickeln, der diese Nachteile nicht aufweist. Es ist somit eine der Aufgaben der vorliegenden Erfindung, derartige Leuchtstoffe bereitzustellen.

Überraschenderweise haben die Erfinder herausgefunden, dass Samarium-dotierte Terbiummolybdate den oben genannten Anforderungen entsprechen.

CN 103275713 A offenbart Verbindungen der allgemeinen Formel

R^{III}₂₍₁₋ₓ₎Eu₂ₓMo₄O₁₅

worin R^{III} ausgewählt ist aus den Elementen La³⁺, Ce³⁺, Pr³⁺, Nd³⁺, Sm³⁺, Gd³⁺, Tb³⁺, Dy³⁺, Ho³⁺, Er³⁺, Tm³⁺, Yb³⁺, Lu³⁺, Sc³⁺ und Y³⁺ und 0.0001 ≤ x < 1.0 ist. Die erfindungsgemäßen Terbiummolybdate werden hier allerdings nicht offenbart. Wie dem Fachmann zudem bekannt ist, bildet sich bei der Herstellung von Verbindungen der oben genannten Formel neben Tb³⁺, zusätzlich Tb⁴⁺, was die Leuchtstoffeigenschaften der entsprechenden Verbindungen deutlich verschlechtert, da entsprechende Tb⁴⁺-Anteile in den Verbindungen eine breite Absorptionsbande hervorrufen, welche unvorteilhaft bis in den Bereich des roten Lichts reicht.

Aus der US-Patentveröffentlichung US 3,437,432 sind stabile Einkristall-Leuchtstoffe mit Gadolinium-Molybdatstruktur, die die allgemeine Formel (RₓR'₁₋ₓ)₂O₃·3Mo₁₋ₑWₑO₃ (mit R und R' = mind. ein Seltenerdmetallelement der Atomnummern 57-71, Scandium und Yttrium; x = 0-1,0 und e = 0-0,2) aufweisen, bekannt. Als Beispiele werden (Tb_{0.9}Eu_{0.1})₂O₃·MoO₃ und (Tb_{0.5}Eu_{0.5})₂O₃·MoO₃ beschrieben, die jeweils lediglich ein Emissionsmaximum im roten Spektralbereich bei etwa 615 nm aufweisen.

Gegenstand der vorliegenden Erfindung ist daher eine Verbindung der Formel I,

(Tb₂)ₓ(Mo_{1-b}W_{b})_{y}O_{3x+3y} : Sm³⁺ I

worin
- x: 1, 2 oder 3; 1 ≤ y ≤ 3; und 0 ≤ b < 1, bedeuten.

Vorzugsweise entspricht y einem ganzzahligen Vielfachen von 1 bis 3.

Die erfindungsgemäßen Verbindungen sind üblicherweise im blauen Spektralbereich, vorzugsweise bei etwa 370 - 480 nm, anregbar und weisen üblicherweise rote Linienemission im roten Spektralbereich bei ca. 615 bzw. 660 nm auf.

Im Kontext dieser Anmeldung wird als blaues Licht solches Licht bezeichnet, dessen Emissionsmaximum zwischen 400 und 459 nm liegt, als cyanfarbenes Licht solches, dessen Emissionsmaximum zwischen 460 und 505 nm liegt, als grünes Licht solches, dessen Emissionsmaximum zwischen 506 und 545 nm liegt, als gelbes Licht solches, dessen Emissionsmaximum zwischen 546 und 565 nm liegt, als orange Licht solches, dessen Emissionsmaximum zwischen 566 und 600 nm liegt und als rotes Licht solches, dessen Emissionsmaximum zwischen 601 und 700 nm liegt. Die erfindungsgemäße Verbindung ist vorzugsweise ein rotemittierender Konversionsleuchtstoff.

Ferner zeichnen sich die erfindungsgemäßen Verbindungen durch eine hohe Photolumineszenzquantenausbeute von mehr als 80%, bevorzugt mehr als 90%, besonders bevorzugt von mehr als 95% aus.

Die Photolumineszenzquantenausbeute (auch Quantenausbeute oder Quanteneffizienz genannt) beschreibt das Verhältnis zwischen der Anzahl der emittierten und absorbierten Photonen einer Verbindung.

Zudem weisen die erfindungsgemäßen Leuchtstoffe hohe Werte für das Lumenäquivalent (≥ 250 lm/W) auf und zeichnen sich ferner durch eine hohe chemische und photochemische Stabilität aus.

In einer bevorzugten Ausführungsform, sind die Verbindungen der Formel I ausgewählt aus der Formel Ia,

(Tb₂₋ₐSm³⁺ₐ)ₓ(Mo_{1-b}W_{b})_{y}O_{3x+3y} Ia

worin
b eine der unter Formel I angegebenen Bedeutungen hat,
x = 1;
1 ≤ y ≤ 3; und
0,1 ≤ a ≤ 1 ist.

Die erfindungsgemäßen Verbindungen zeichnen sich insbesondere durch eine für Sm³⁺-dotierte Leuchtstoffe vergleichsweise hohe Absorptionsstärke bei 395 nm, 465 nm und 487 nm aus. Die letztgenannte Absorptionsbande ist durch die Anwesenheit des trivalenten Tb³⁺ bedingt (⁷F₆ - ⁵D₄), wobei durch effizienten Energietransfer zu Sm³⁺ bei einer Konzentration 0,2 ≤ a ≤ 1 die "grüne" Tb³⁺ Lumineszenz fast vollständig gelöscht ist.

In einer bevorzugten Ausführungsform ist in den erfindungsgemäßen Verbindungen der Formel Ia 0,2 < a ≤ 1 ist, ferner 0,4 ≤ a ≤ 1.

Erfindungsgemäß kann das Emissionsmaximum der Verbindungen der Formeln I und Ia mit Sm³⁺ bei Bedarf auch in den gelben Spektralbereich verschoben werden, indem man weniger Sm³⁺ hineindotiert, besonders bevorzugt sind dabei Verbindungen in denen 0 < a < 0,1, bevorzugt 0 < a ≤ 0,05, besonders bevorzugt 0 < a ≤ 0,01 ist.

In einer weiteren Ausführungsform kann das hexavalente Molybdän in den Verbindungen der Formeln I und Ia partiell durch hexavalentes Wolfram ausgetauscht werden (b > 0). Bevorzugt sind hierbei Verbindungen worin 0 ≤ b < 0,8, besonders bevorzugt worin 0 ≤ b < 0,5, insbesondere worin 0 ≤ b < 0,3 ist. Insbesondere bevorzugt sind jedoch Verbindungen der Formeln I und Ia, worin b gleich 0 ist.

Besonders bevorzugt sind Verbindungen der Formeln I und Ia, worin x gleich 1 ist und y gleichzeitig gleich 3 ist.

Als Mischkristall wird ein Kristall bezeichnet, der aus mindestens zwei verschiedenen chemischen Elementen besteht, wobei die entsprechenden Atome oder Ionen statistisch verteilt sind.

Besonders bevorzugt sind die erfindungsgemäßen Verbindungen, ausgewählt aus den folgenden Unterformeln: Tb_{1.8}SM_{0.2}Mo₃O₁₂, Tb_{1,6}Sm_{0,4}Mo₃O₁₂, Tb_{1.4}Sm_{0.6}Mo₃O₁₂, Tb_{1.2}Sm_{0.8}Mo₃O₁₂ und Tb_{1.0}Sm_{1.0}Mo₃O₁₂.

Bevorzugt liegen die Verbindungen der Formeln I und Ia dabei phasenrein vor.

Anhand eines Röntgendiffraktogramms lässt sich die Phasenreinheit eines kristallinen Pulvers untersuchen, d. h. ob die Probe nur aus einer kristallinen (phasenrein) oder mehreren (mehrphasig) Verbindungen besteht. In phasenreinen Pulvern können alle Reflexe beobachtet und der Verbindung zugeordnet werden.

Ein weiterer Gegenstand der vorliegenden Erfindung ist ein Verfahren zur Herstellung einer erfindungsgemäßen Verbindung, dadurch gekennzeichnet, dass in einem Schritt a) geeignete Edukte, ausgewählt aus Nitriden und Oxiden oder entsprechenden reaktiven Formen, gemischt werden und das Gemisch in einem Schritt b) thermisch behandelt wird.

Bevorzugt ist das Verfahren gekennzeichnet durch die folgenden Verfahrensschritte:
(a) Herstellung einer Mischung enthaltend eine Samariumquelle, eine Molybdänquelle und eine Terbiumquelle, sowie gegbenenfalls eine Wolframquelle;
(b) Kalzinieren der Mischung unter oxidierenden Bedingungen.

Als Samariumquelle in Schritt (a) kann jegliche denkbare Samariumverbindung eingesetzt werden, mit der ein Samariumdotiertes Terbiummolybdat hergestellt werden kann. Vorzugsweise werden als Samariumquelle Oxide oder Nitride von Samarium eingesetzt, insbesondere Samariumoxid (vor allem Sm₂O₃) und/oder Samariumnitrid (SmN), insbesondere Sm₂O₃.

Als Terbiumquelle im Schritt (a) kann jegliche denkbare Terbiumverbindung eingesetzt werden, mit der ein Europium-dotiertes Terbiummolybdat hergestellt werden kann. Vorzugsweise werden im erfindungsgemäßen Verfahren als Terbiumquelle Terbiumnitrid und/oder Terbiumoxid eingesetzt.

Als Molybdän- und/oder Wolframquelle im Schritt (a) kann jegliche denkbare Molybdän- und/oder Wolframverbindung eingesetzt werden, mit der ein erfindungsgemäßes Terbiummolybdat hergestellt werden kann. Vorzugsweise werden im erfindungsgemäßen Verfahren als Molybdän- und/oder Wolframquelle entsprechende Nitride und/oder Oxide eingesetzt.

Die Verbindungen werden vorzugsweise in einem Verhältnis so zueinander eingesetzt, dass die Atomanzahl der entsprechenden Elemente Sm, des Molybdäns und/oder Wolframs, sowie des Terbiums im Wesentlichen dem gewünschten Verhältnis im Produkt der oben genannten Formeln entspricht. Dabei wird insbesondere ein stöchiometrisches Verhältnis verwendet.

Die Ausgangsverbindungen in Schritt (a) werden bevorzugt in Pulverform eingesetzt und miteinander, beispielsweise durch einen Mörser, zu einer homogenen Mischung verarbeitet. Vorzugsweise können zu diesem Zweck die Ausgangsverbindungen in einem inerten, dem Fachmann bekannten, organischen Lösungsmittel suspendiert werden, beispielsweise Aceton. In diesem Fall wird die Mischung vor Kalzinierung getrocknet.

Die Kalzinierung in Schritt (b) wird unter oxidierenden Bedingungen durchgeführt. Unter oxidierenden Bedingungen werden jegliche denkbare oxidierende Atmosphären verstanden, wie z.B. Luft oder andere sauerstoffhaltigen Atmosphären.

Die Kalzinierung wird bevorzugt bei einer Temperatur im Bereich von 700 °C bis 1200 °C, besonders bevorzugt 800 °C bis 1000 °C und insbesondere 850 °C bis 950 °C durchgeführt. Dabei beträgt der Zeitraum der Kalzinierung bevorzugt 2 bis 14 h, stärker bevorzugt 4 bis 12 h und insbesondere 6 bis 10 h.

Die Kalzinierung wird vorzugsweise so durchgeführt, dass die erhaltenen Mischungen beispielsweise in einem Gefäß aus Bornitrid in einen Hochtemperaturofen eingebracht werden. Der Hochtemperaturofen ist beispielsweise ein Rohrofen, der eine Trägerplatte aus Molybdänfolie enthält.

Nach dem Kalzinieren werden die erhaltenen Verbindungen optional homogenisiert, wobei ein entsprechender Mahlprozesss nass in einem geeigneten Lösungsmittel, beispielsweise in Isopropanol, oder trocken erfolgen kann.

In einer weiteren Ausführungsform können die erfindungsgemäßen Verbindungen beschichet werden. Hierfür eignen sich alle Beschichtungsverfahren, wie sie gemäß dem Stand der Technik dem Fachmann bekannt sind und für Phosphore angewandt werden. Geeignete Materialien für die Beschichtung sind insbesondere Metalloxide und Metallnitride, insbesondere Erdmetalloxide, wie Al₂O₃, und Erdmetallnitride, wie AlN, sowie SiO₂. Dabei kann die Beschichtung beispielsweise durch Wirbelschichtverfahren durchgeführt werden. Weitere geeignete Beschichtungsverfahren sind bekannt aus JP 04-304290, WO 91/10715, WO 99/27033, US 2007/0298250, WO 2009/065480 und WO 2010/075908. Es ist auch möglich, alternativ zur oben genannten anorganischen Beschichtung und/oder zusätzlich eine organische Beschichtung aufzubringen. Die Beschichtung kann sich vorteilhaft auf die Stabilität der Verbindungen sowie die Dispergierbarkeit auswirken.

Ein weiterer Gegenstand der vorliegenden Erfindung ist die Verwendung der erfindungsgemäßen Verbindung als Leuchtstoff, insbesondere als Konversionsleuchtstoff.

Unter dem Begriff "Konversionsleuchtstoff" im Sinne der vorliegenden Anmeldung wird ein Material verstanden, das in einem bestimmten Wellenlängenbereich des elektromagnetischen Spektrums, vorzugsweise im blauen oder im UV-Spektralbereich, Strahlung absorbiert und in einem anderen Wellenlängenbereich des elektromagnetischen Spektrums, vorzugsweise im roten oder orange Spektralbereich, insbesondere im roten Spektralbereich, sichtbares Licht emittiert. In diesem Zusammenhang ist auch der Begriff "strahlungsinduzierte Emissionseffizienz" zu verstehen, d. h. der Konversionsleuchtstoff absorbiert Strahlung in einem bestimmten Wellenlängenbereich und emittiert Strahlung in einem anderen Wellenlängenbereich mit einer bestimmten Effizienz. Unter dem Begriff "Verschiebung der Emissionswellenlänge" versteht man, dass ein Konversionsleuchtstoff im Vergleich zu einem anderen oder ähnlichen Konversionsleuchtstoff Licht bei einer anderen Wellenlänge emittiert, das heißt verschoben zu einer kleineren oder größeren Wellenlänge. Es wird also das Emissionsmaximum verschoben.

Ein weiterer Gegenstand der vorliegenden Erfindung ist ein emissionskonvertierendes Material umfassend eine oder mehrere erfindungsgemäße Verbindungen gemäß einer der oben aufgeführten Formeln. Das emissions-konvertierende Material kann aus einer der erfindungsgemäßen Verbindungen bestehen und wäre in diesem Fall mit dem oben definierten Begriff "Konversionsleuchtstoff" gleichzusetzen.

Es ist auch möglich, dass das erfindungsgemäße emissions-konvertierende Material neben der erfindungsgemäßen Verbindung noch weitere Konversionsleuchtstoffe enthält. In diesem Fall enthält das erfindungsgemäße emissions-konvertierende Material eine Mischung aus mindestens zwei Konversionsleuchtstoffen, wobei einer davon eine erfindungsgemäße Verbindung ist. Es ist insbesondere bevorzugt, dass die mindestens zwei Konversionsleuchtstoffe Leuchtstoffe sind, die Licht unterschiedlicher Wellenlängen emittieren, die komplementär zueinander sind. Da es sich bei der erfindungsgemäßen Verbindung um einen rot emittierenden Leuchtstoff handelt, wird dieser bevorzugt in Kombination mit einem grün oder gelb emittierenden Leuchstoff oder auch mit einem cyan oder blau emittierenden Leuchtstoff eingesetzt. Alternativ dazu kann auch der erfindungsgemäße rot-emittierende Konversionsleuchtstoff in Kombination mit (einem) blau- und grün-emitierenden Konversionsleuchtstoff(en) eingesetzt werden. Alternativ dazu kann auch der erfindungsgemäße rot-emittierende Konversionsleuchtstoff in Kombination mit (einem) grün-emittierenden Konversionsleuchtstoff(en) eingesetzt werden. Es kann also bevorzugt sein, dass der erfindungsgemäße Konversionsleuchtstoff in Kombination mit einem oder mehreren weiteren Konversionsleuchtstoffen in dem erfindungsgemäße Emissions-konvertierenden Material eingesetzt wird, die dann zusammen vorzugsweise weißes Licht emittieren.

Als weiterer Konversionsleuchtstoff, der zusammen mit der erfindungsgemäßen Verbindung eingesetzt werden kann, kann generell jeder mögliche Konversionsleuchtstoff eingesetzt werden. Dabei eignen sich beispielsweise: Ba₂SiO₄:Eu²⁺, BaSi₂O₅:Pb²⁺, BaₓSr₁₋ₓF₂:Eu²⁺, BaSrMgSi₂O₇:Eu²⁺, BaTiP₂O₇, (Ba,Ti)₂P₂O₇:Ti, Ba₃WO₆:U, BaY₂F₈:Er³⁺,Yb⁺, Be₂SiO₄:Mn²⁺, Bi₄Ge₃O₁₂, CaAl₂O₄:Ce³⁺, CaLa₄O₇:Ce³⁺, CaAl₂O₄:Eu²⁺, CaAl₂O₄:Mn²⁺, CaAl₄O₇:Pb²⁺, Mn²⁺, CaAl₂O₄:Tb³⁺, Ca₃Al₂Si₃O₁₂:Ce³+, Ca₃Al₂Si₃Oi₂:Ce³⁺, Ca₃Al₂Si₃O₂:Eu²+, Ca₂B₅O₉Br:Eu²⁺, Ca₂B₅O₉Cl:Eu²⁺, Ca₂B₅O₉Cl:Pb²⁺, CaB₂O₄:Mn²⁺, Ca₂B₂O₅:Mn²⁺, CaB₂O₄:Pb²⁺, CaB₂P₂O₉:Eu²⁺, Ca₅B₂SiO₁₀:Eu³⁺, Ca_{0.5}Ba_{0.5}Al₁₂O₁₉:Ce³⁺,Mn²⁺, Ca₂Ba₃(PO₄)₃Cl:Eu²⁺, CaBr₂:Eu²⁺ in SiO₂, CaCl₂:Eu²⁺ in SiO₂, CaCl₂:Eu²⁺,Mn²⁺ in SiO₂, CaF₂:Ce³⁺, CaF₂:Ce³⁺,Mn²⁺, CaF₂:Ce³⁺,Tb³⁺, CaF₂:Eu²⁺, CaF₂:Mn²⁺, CaF₂:U, CaGa₂O₄:Mn²⁺, CaGa₄O₇:Mn²⁺, CaGa₂S₄:Ce³⁺, CaGa₂S₄:Eu²⁺, CₐGa₂S₄:Mn²⁺, CaGa₂S₄:Pb²⁺, CaGeO₃:Mn²⁺, Cal₂:Eu²⁺ in SiO₂, Cal₂:Eu²⁺,Mn²⁺ in SiO₂, CaLaBO₄:Eu³⁺, CaLaB₃O₇:Ce³⁺,Mn²⁺, Ca₂La₂BO_{6.5}:Pb²⁺, Ca₂MgSi₂O₇, Ca₂MgSi₂O₇:Ce³⁺, CaMgSi₂O₆:Eu²⁺, Ca₃MgSi₂O₈:Eu²⁺, Ca₂MgSi₂O₇:Eu²⁺ CaMgSi₂O₆:Eu²⁺,Mn²⁺, Ca₂MgSi₂O₇:Eu²⁺,Mn²⁺, CaMoO₄, CaMoO₄:Eu³⁺, CaO:Bi³⁺, CaO:Cd²⁺, CaO:Cu⁺, CaO:Eu³⁺, CaO:Eu³⁺, Na⁺, CaO:Mn²⁺, CaO:Pb²⁺, CaO:Sb³⁺, CaO:Sm³⁺, CaO:Tb³⁺, CaO:Tl, CaO:Zn²⁺, Ca₂P₂O₇:Ce³⁺, α-Ca₃(PO₄)₂:Ce³⁺, β-Ca₃(PO₄)₂:Ce³⁺, Ca₅(PO₄)₃Cl:Eu²⁺, Ca₅(PO₄)₃Cl:Mn²⁺, Ca₅(PO₄)₃Cl:Sb³⁺, Ca₅(PO₄)₃Cl:Sn²⁺, β-Ca₃(PO₄)₂:Eu²+,Mn²⁺, Ca₅(PO₄)₃F:Mn²⁺, Caₛ(PO₄)₃F:Sb³⁺, Caₛ(PO₄)₃F:Sn²⁺, α-Ca₃(PO₄)₂:Eu²⁺, β-Ca₃(PO₄)₂:Eu²⁺, Ca₂P₂O₇:Eu²⁺, Ca₂P₂O₇:Eu²⁺,Mn²⁺, CaP₂O₆:Mn²⁺, α-Ca₃(PO₄)₂:Pb²⁺, α-Ca₃(PO₄)₂:Sn²⁺, β-Ca₃(PO₄)₂:Sn²⁺, β-Ca₂P₂O₇:Sn,Mn, α-Ca₃(PO₄)₂:Tr, CaS:Bi³⁺, CaS:Bi³⁺,Na, CaS:Ce³⁺, CaS:Eu²⁺, CaS:Cu⁺,Na⁺, CaS:La³⁺, CaS:Mn²⁺, CaSO₄:Bi, CaSO₄:Ce³⁺, CaSO₄:Ce³⁺,Mn²⁺, CaSO₄:Eu²⁺, CaSO₄:Eu²⁺,Mn²⁺, CaSO₄:Pb²⁺, CaS:Pb²⁺, CaS:Pb²⁺,Cl, CaS:Pb²⁺,Mn²⁺, CaS:Pr³⁺,Pb²⁺,Cl, CaS:Sb³⁺, CaS:Sb³⁺,Na, CaS:Sm³⁺, CaS:Sn²⁺, CaS:Sn²⁺,F, CaS:Tb³⁺, CaS:Tb³⁺,Cl, CaS:Y³⁺, CaS:Yb²⁺, CaS:Yb²⁺,Cl, CaSiO₃:Ce³⁺, Ca₃SiO₄Cl₂:Eu²⁺, Ca₃SiO₄Cl₂:Pb²⁺, CaSiO₃:Eu²⁺, CaSiO₃:Mn²⁺, Pb, CaSiO₃:Pb²⁺, CaSiO₃:Pb²⁺,Mn²⁺, CaSiO₃:Ti⁴⁺, CaSr₂(PO₄)₂:Bi³⁺, β-(Ca,Sr)₃(PO₄)₂:Sn²⁺Mn²⁺, CaTi_{0.9}Al_{0.1}O₃:Bi³⁺, CaTiO₃:Eu³⁺, CaTiO₃:Pr³⁺, Ca₅(VO₄)₃Cl, CaWO₄, CaWO₄:Pb²⁺, CaWO₄:W, Ca₃WO₆:U, CaYAlO₄:Eu³⁺, CaYBO₄:Bi³⁺, CaYBO₄:Eu³⁺, CaYB_{0.8}O_{3.7}:Eu³⁺, CaY₂ZrO₆:Eu³⁺, (Ca,Zn,Mg)₃(PO₄)₂:Sn, CeF₃, (Ce,Mg)BaAl₁₁O₁₈:Ce, (Ce,Mg)SrAl₁₁O₁₈:Ce, CeMgAl₁₁O₁₉:Ce:Tb, Cd₂B₆O₁₁:Mn²⁺, CdS:Ag⁺,Cr, CdS:In, CdS:In, CdS:In,Te, CdS:Te, CdWO₄, CsF, Csl, CsI:Na⁺, CsI:Tl, (ErCl₃)_{0.25}(BaCl₂)_{0.75}, GaN:Zn, Gd₃Ga₅O₁₂:Cr³⁺, Gd₃Ga₅O₁₂:Cr,Ce, GdNbO₄:Bi³⁺, Gd₂O₂S:Eu³⁺, Gd₂O₂Pr³⁺, Gd₂O₂S:Pr,Ce,F, Gd₂O₂S:Tb³⁺, Gd₂SiO₅:Ce³⁺, KAl₁₁O₁₇:Tl⁺, KGa₁₁O₁₇:Mn²⁺, K₂La₂Ti₃O₁₀:Eu, KMgF₃:Eu²⁺, KMgF₃:Mn²⁺, K₂SiF₆:Mn⁴⁺, LaAl₃B₄O₁₂:Eu³⁺, LaAlB₂O₆:Eu³⁺, LaAlO₃:Eu³⁺, LaAlO₃:Sm³⁺, LaAsO₄:Eu³⁺, LaBr₃:Ce³⁺, LaBO₃:Eu³⁺, (La,Ce,Tb)PO4:Ce:Tb, LaCl₃:Ce³⁺, La₂O₃:Bi³⁺, LaOBr:Tb³⁺, LaOBr:Tm³⁺, LaOCl:Bi³⁺, LaOCl:Eu³⁺, LaOF:Eu³⁺, La₂O₃:Eu³⁺, La₂O₃:Pr³⁺, La₂O₂S:Tb³⁺, LaPO₄:Ce³⁺, LaPO₄:Eu³⁺, LaSiO₃Cl:Ce³⁺, LaSiO₃Cl:Ce³⁺,Tb³⁺, LaVO₄:Eu³⁺, La₂W₃O₁₂:Eu³⁺, LiAlF₄:Mn²⁺, LiAl₅O₈:Fe³⁺, LiAlO₂:Fe³⁺, LiAlO₂:Mn²⁺, LiAl₅O₈:Mn²⁺, Li₂CaP₂O₇:Ce³⁺,Mn²⁺, LiCeBa₄Si₄O₁₄:Mn²⁺, LiCeSrBa₃Si₄O₁₄:Mn²+, LiInO₂:Eu³⁺, LiInO₂:Sm³⁺, LiLaO₂:Eu³⁺, LuAlO₃:Ce³⁺, (Lu,Gd)₂Si0₅:Ce³⁺, Lu₂SiO₅:Ce³⁺, Lu₂Si₂O₇:Ce³⁺, LuTaO₄:Nb⁵⁺, Lu₁₋ₓYₓAlO₃:Ce³⁺, MgAl₂O₄:Mn²⁺, MgSrAl₁₀O₁₇:Ce, MgB₂O₄:Mn²⁺, MgBa₂(PO₄)₂:Sn²⁺, MgBa₂(PO₄)₂:U, MgBaP₂O₇:Eu²⁺, MgBaP₂O₇:Eu²⁺,Mn²⁺, MgBa₃Si₂O₈:Eu²⁺, MgBa(SO₄)₂:Eu²⁺, Mg₃Ca₃(PO₄)₄:Eu²⁺, MgCaP₂O₇:Mn²⁺, Mg₂Ca(SO₄)₃:Eu²⁺, Mg₂Ca(SO₄)₃:Eu²⁺,Mn², MgCeAlₙO₁₉:Tb³⁺, Mg₄(F)GeO₆:Mn²⁺, Mg₄(F)(Ge,Sn)O₆:Mn²⁺, MgF₂:Mn²⁺, MgGa₂O₄:Mn²⁺, Mg₈Ge₂O₁₁F₂:Mn⁴⁺, MgS:Eu²⁺, MgSiO₃:Mn²⁺, Mg₂SiO₄:Mn²⁺, Mg₃SiO₃F₄:Ti⁴⁺, MgSO₄:Eu²⁺, MgSO₄:Pb²⁺, MgSrBa₂Si₂O₇:Eu²⁺, MgSrP₂O₇:Eu²⁺, MgSr₅(PO₄)₄:Sn²⁺, MgSr₃Si₂O₈:Eu²⁺,Mn²⁺, Mg₂Sr(SO₄)₃:Eu²⁺, Mg₂TiO₄:Mn⁴⁺, MgWO₄, MgYBO₄:Eu³⁺, Na₃Ce(PO₄)₂:Tb³⁺, NaI:Tl, Na_{1.23}K_{0.42}Eu_{0.12}TiSi₄O₁₁:Eu³⁺, Na_{1.23}K_{0.42}Eu_{0.12}TiSi₅O₁₃·xH₂O:Eu³⁺, Na_{1.29}K_{0.46}Er_{0.08}TiSi₄O₁₁:Eu³⁺, Na₂Mg₃Al₂Si₂O₁₀:Tb, Na(Mg₂₋ₓMnₓ)LiSi₄O₁₀F₂:Mn, NaYF₄:Er³⁺, Yb³⁺, NaYO₂:Eu³⁺, P46(70%) + P47 (30%), SrAl₁₂O₁₉:Ce³⁺, Mn²⁺, SrAl₂O₄:Eu²⁺, SrAl₄O₇:Eu³⁺, SrAl₁₂O₁₉:Eu²⁺, SrAl₂S₄:Eu²⁺, Sr₂B₅O₉Cl:Eu²⁺, SrB₄O₇:Eu²⁺(F,Cl,Br), SrB₄O₇:Pb²⁺, SrB₄O₇:Pb²⁺, Mn²⁺, SrB₈O₁₃:Sm²⁺, SrₓBa_{y}Cl_{z}Al₂0_{4-z/2}: Mn²⁺, Ce³⁺, SrBaSiO₄:Eu²⁺, Sr(Cl,Br,I)₂:Eu²⁺ in SiO₂, SrCl₂:Eu²⁺ in SiO₂, Sr₅Cl(PO₄)₃:Eu, Sr_{w}FₓB₄O_{6.5}:Eu²⁺, Sr_{w}FₓB_{y}O_{z}:Eu²⁺,Sm²⁺, SrF₂:Eu²⁺, SrGa₁₂O₁₉:Mn²⁺, SrGa₂S₄:Ce³⁺, SrGa₂S₄:Eu²⁺, SrGa₂S₄:Pb²⁺, SrIn₂O₄:Pr³⁺, Al³⁺, (Sr,Mg)₃(PO₄)₂:Sn, SrMgSi₂O₆:Eu²⁺, Sr₂MgSi₂O₇:Eu²⁺, Sr₃MgSi₂O₈:Eu²⁺, SrMoO₄:U, SrO·3B₂O₃:Eu²⁺,Cl, β-SrO·3B₂O₃:Pb²⁺, β-SrO·3B₂O₃ :Pb²⁺,Mn²⁺, α-SrO·3B₂O₃:Sm²⁺, Sr₆P₅BO₂₀:Eu, Sr₅(PO₄)₃Cl:Eu²⁺, Sr₅(PO₄)₃Cl:Eu²⁺,Pr³⁺, Sr₅(PO₄)₃Cl:Mn²⁺, Sr₅(PO₄)₃Cl:Sb³⁺, Sr₂P₂O₇:Eu²⁺, β-Sr₃(PO₄)₂:Eu²⁺, Sr₅(PO₄)₃F:Mn²⁺, Sr₅(PO₄)₃F:Sb³⁺, Sr₅(PO₄)₃F:Sb³⁺,Mn²⁺, Sr₅(PO₄)₃F:Sn²⁺, Sr₂P₂O₇:Sn²⁺, β-Sr₃(PO₄)₂:Sn²⁺, β-Sr₃(PO₄)₂:Sn²⁺,Mn²⁺(Al), SrS:Ce³⁺, SrS:Eu²⁺, SrS:Mn²⁺, SrS:Cu⁺,Na, SrSO₄:Bi, SrSO₄:Ce³⁺, SrSO₄:Eu²⁺, SrSO₄:Eu²⁺,Mn²+, Sr₅Si₄O₁₀Cl₆:Eu²⁺, Sr₂SiO₄:Eu²⁺, SrTiO₃:Pr³⁺, SrTiO₃:Pr³⁺,Al³⁺, Sr₃WO₆:U, SrY₂O₃:Eu³⁺, ThO₂:Eu³⁺, ThO₂:Pr³⁺, ThO₂:Tb³⁺, YAl₃B₄O₁₂:Bi³⁺, YAl₃B₄O₁₂:Ce³⁺, YAl₃B₄O₁₂:Ce³⁺,Mn, YAl₃B₄O₁₂:Ce³⁺,Tb³⁺, YAl₃B₄O₁₂:Eu³⁺, YAl₃B₄O₁₂:Eu³⁺,Cr³⁺, YAl₃B₄O₁₂:Th⁴⁺,Ce³⁺,Mn²⁺, YAlO₃:Ce³⁺, Y₃Al₅O₁₂:Ce³⁺, Y₃Al₅O₁₂:Cr³⁺, YAlO₃:Eu³⁺, Y₃Al₅O₁₂:Eu^{3r}, Y₄Al₂O₉:Eu³⁺, Y₃Al₅O₁₂:Mn⁴⁺, YAlO₃:Sm³⁺, YAlO₃:Tb³⁺, Y₃Al₅O₁₂:Tb³⁺, YAsO₄:Eu³⁺, YBO₃:Ce³⁺, YBO₃:Eu³⁺, YF₃:Er³⁺,Yb³⁺, YF₃:Mn²⁺, YF₃:Mn²⁺,Th⁴⁺, YF₃:Tm³⁺,Yb³⁺, (Y,Gd)BO₃:Eu, (Y,Gd)BO₃:Tb, (Y,Gd)₂O₃:Eu³⁺, Y_{1.34}Gd_{0.60}O₃(Eu,Pr), Y₂O₃:Bi³⁺, YOBr:Eu³⁺, Y₂O₃:Ce, Y₂O₃:Er³⁺, Y₂O₃:Eu³⁺(YOE), Y₂O₃:Ce³⁺,Tb³⁺, YOCl:Ce³⁺, YOCl:Eu³⁺, YOF:Eu³⁺, YOF:Tb³⁺, Y₂O₃:Ho³⁺, Y₂O₂S:Eu³⁺, Y₂O₂S:Pr³⁺, Y₂O₂S:Tb³⁺, Y₂O₃:Tb³⁺, YPO₄:Ce³⁺, YPO₄:Ce³⁺,Tb³⁺, YPO₄:Eu³⁺, YPO₄:Mn²⁺,Th⁴⁺, YPO₄:V⁵⁺, Y(P,V)O₄:Eu, Y₂SiO₅:Ce³⁺, YTaO₄, YTaO₄:Nb⁵⁺, YVO₄:Dy³⁺, YVO₄:Eu³⁺, ZnAl₂O₄:Mn²⁺, ZnB₂O₄:Mn²⁺, ZnBa₂S₃:Mn²⁺, (Zn,Be)₂SiO₄:Mn²⁺, Zn_{0.4}ACd_{0.6}S:Ag, Zn_{0.6}Cd_{0.4}S:Ag, (Zn,Cd)S:Ag,Cl, (Zn,Cd)S:Cu, ZnF₂:Mn²⁺, ZnGa₂O₄, ZnGa₂O₄:Mn²⁺, ZnGa₂S₄:Mn²⁺, Zn₂GeO₄:Mn²⁺, (Zn,Mg)F₂:Mn²⁺, ZnMg₂(PO₄)₂:Mn²⁺, (Zn,Mg)₃(PO₄)₂:Mn²⁺, ZnO:Al³⁺,Ga³⁺, ZnO:Bi³⁺, ZnO:Ga³⁺, ZnO:Ga, ZnO-CdO:Ga, ZnO:S, ZnO:Se, ZnO:Zn, ZnS:Ag⁺,Cl⁻, ZnS:Ag,Cu,Cl, ZnS:Ag,Ni, ZnS:Au,In, ZnS-CdS (25-75), ZnS-CdS (50-50), ZnS-CdS (75-25), ZnS-CdS:Ag,Br,Ni, ZnS-CdS:Ag⁺,Cl, ZnS-CdS:Cu,Br, ZnS-CdS:Cu,I, ZnS:Cl⁻, ZnS:Eu²⁺, ZnS:Cu, ZnS:Cu⁺,Al³⁺, ZnS:Cu⁺,Cl⁻, ZnS:Cu,Sn, ZnS:Eu²⁺, ZnS:Mn²⁺, ZnS:Mn,Cu, ZnS:Mn²+,Te²⁺, ZnS:P, ZnS:P³-,Cl⁻, ZnS:Pb²⁺, ZnS:Pb²⁺,Cl⁻, ZnS:Pb,Cu, Zn₃(PO₄)₂:Mn²⁺, Zn₂SiO₄:Mn²⁺, Zn₂SiO₄:Mn²⁺,As⁵⁺, Zn₂SiO₄:Mn,Sb₂O₂, Zn₂SiO₄:Mn²⁺,P, Zn₂SiO₄:Ti⁴⁺, ZnS:Sn²⁺, ZnS:Sn,Ag, ZnS:Sn²⁺,Li⁺, ZnS:Te,Mn, ZnS-ZnTe:Mn²⁺, ZnSe:Cu⁺,Cl oder ZnWO₄.

Erfindungsgemäße Verbindungen, in geringen Mengen eingesetzt, ergeben bereits gute LED-Qualitäten. Die LED-Qualität wird dabei über übliche Parameter, wie beispielsweise den Color Rendering Index, die Correlated Color Temperature, Lumenäquivalente oder absolute Lumen, bzw. den Farbpunkt in CIE x und CIE y Koordinaten beschrieben.

Der Color Rendering Index oder CRI ist eine dem Fachmann geläufige, einheitslose lichttechnische Größe, welche die Farbwiedergabetreue einer künstlichen Lichtquelle mit derjenigen des Sonnenlichtes bzw. Filamentlichtquellen vergleicht (die beiden letztgenannten besitzen einen CRI von 100).

Die CCT oder Correlated Color Temperature ist eine dem Fachmann geläufige, lichttechnische Größe mit der Einheit Kelvin. Je höher der Zahlenwert, desto kälter erscheint dem Betrachter das Weißlicht einer künstlichen Strahlungsquelle. Die CCT folgt dem Konzept des Schwarzlichtstrahlers, dessen Farbtemperatur der sog. Planckschen Kurve im CIE Diagramm verläuft.

Das Lumenäquivalent ist eine dem Fachmann geläufige lichttechnische Größe mit der Einheit lm/W, die beschreibt, wie groß der photometrische Lichtstrom in Lumen einer Lichtquelle bei einer bestimmten radiometrischen Strahlungsleistung mit der Einheit Watt, ist. Je höher das Lumenäquivalent ist, desto effizienter ist eine Lichtquelle.

Das Lumen ist eine dem Fachmann geläufige, photometrische lichttechnische Größe, welche den Lichtstrom einer Lichtquelle, der ein Maß für die gesamte von einer Strahlungsquelle ausgesandte sichtbare Strahlung ist, beschreibt. Je größer der Lichtstrom, desto heller erscheint die Lichtquelle dem Beobachter.

CIE x und CIE y stehen für die Koordinaten im dem Fachmann geläufigen CIE Normfarbdiagramm (hier Normalbeobachter 1931), mit denen die Farbe einer Lichtquelle beschrieben wird.

Alle oben aufgeführten Größen werden nach dem Fachmann geläufigen Methoden aus Emissionsspektren der Lichtquelle berechnet.

In diesem Zusammenhang ist ein weiterer Gegenstand der vorliegenden Erfindung die Verwendung der erfindungsgemäße Verbindungen oder des zuvor beschriebenen erfindungsgemäßen Emissions-konvertierenden Materials in einer Lichtquelle.

Besonders bevorzugt ist die Lichtquelle eine LED, insbesondere eine phosphorkonvertierte LED, kurz pc-LED. Hierbei ist es besonders bevorzugt, dass das emissions-konvertierende Material neben dem erfindungsgemäßen Konversionsleuchtstoff mindestens einen weiteren Konversionsleuchtstoff umfasst, insbesondere so, dass die Licht-quelle weißes Licht oder Licht mit einem bestimmten Farbpunkt (Color-on-demand-Prinzip) emittiert. Unter "Color-on-demand-Prinzip" versteht man die Realisierung von Licht eines bestimmten Farbpunktes mit einer pc-LED unter Einsatz eines oder mehrerer Konversionsleuchtstoffe.

Ein weiterer Gegenstand der vorliegenden Erfindung ist somit eine Licht-quelle, die eine Primärlichtquelle und das emissions-konvertierende Material umfasst.

Auch hier ist es insbesondere bevorzugt, dass das Emissions-konvertierende Material neben dem erfindungsgemäßen Konversionsleuchtstoff mindestens einen weiteren Konversionsleuchtstoff umfasst, so dass die Lichtquelle vorzugsweise weißes Licht oder Licht mit einem bestimmten Farbpunkt emittiert.

Die erfindungsgemäße Lichtquelle ist vorzugsweise eine pc-LED. Eine pc-LED enthält in der Regel eine Primärlichtquelle und ein Emissionskonvertierendes Material. Das erfindungsgemäße emissions-konvertierende Material kann hierfür entweder in einem Harz dispergiert (z.B. Epoxy- oder Siliconharz) oder bei geeigneten Größenverhältnissen direkt auf der Primärlichtquelle oder aber von dieser, je nach Anwendung, entfernt angeordnet sein (letztere Anordnung schließt auch die "Remote Phosphor Technology" mit ein).

Die Primärlichtquelle kann ein Halbleiterchip, eine lumineszente Lichtquelle, wie ZnO, eine sogenanntes TCO (Transparent Conducting Oxide), eine ZnSe oder SiC basierende Anordnung, eine auf einer organischen Licht-emittierenden Schicht basierende Anordnung (OLED) oder eine Plasma- oder Entladungsquelle sein, am stärksten bevorzugt ein Halbleiterchip. Ist die Primärlichtquelle ein Halbleiterchip, so handelt es sich vorzugsweise um ein lumineszentes Indium-Aluminium-Gallium-Nitrid (InAlGaN), wie es im Stand der Technik bekannt ist. Dem Fachmann sind mögliche Formen von derartigen Primärlichtquellen bekannt. Weiterhin geeignet sind Laser als Lichtquelle.

Das erfindungsgemäße emissions-konvertierende Material kann zum Einsatz in Lichtquellen, insbesondere pc-LEDs, auch in beliebige äußeren Formen wie sphärische Partikel, Plättchen sowie strukturierte Materialien und Keramiken überführt werden. Diese Formen werden unter dem Begriff "Formkörper" zusammengefasst. Folglich handelt es sich bei den Formkörpern um emissions-konvertierende Formkörper.

Ein weiterer Erfindungsgegenstand ist eine Beleuchtungseinheit, die mindestens eine erfindungsgemäße Lichtquelle enthält. Solche Beleuchtungseinheiten werden hauptsächlich in Anzeigevorrichtungen, insbesondere Flüssigkristallanzeigevorrichtungen (LC-Display) mit einer Hintergrundbeleuchtung eingesetzt. Daher ist auch eine derartige Anzeigevorrichtung Gegenstand der vorliegenden Erfindung.

In der erfindungsgemäßen Beleuchtungseinheit erfolgt die optische Ankopplung zwischen dem Emissions-konvertierenden Material und der Primärlichtquelle (insbesondere Halbleiterchips) vorzugsweise durch eine lichtleitende Anordnung. Dadurch ist es möglich, dass an einem zentralen Ort die Primärlichtquelle installiert wird und diese mittels lichtleitender Vorrichtungen, wie beispielsweise lichtleitenden Fasern, an das emissions-konvertierende Material optisch angekoppelt ist. Auf diese Weise lassen sich den Beleuchtungswünschen angepasste Leuchten bestehend aus einem oder mehreren unterschiedlichen Konversionsleuchtstoffen, die zu einem Leuchtschirm angeordnet sein können, und einem Lichtleiter, der an die Primärlichtquelle angekoppelt ist, realisieren. Dadurch ist es möglich, eine starke Primärlichtquelle an einem für die elektrische Installation günstigen Ort zu platzieren und ohne weitere elektrische Verkabelung, nur durch Verlegung von Lichtleitern an beliebigen Orten, Leuchten aus Emissions-konvertierenden Materialien, die an die Lichtleiter gekoppelt sind, zu installieren.

Alle hier beschriebenen Erfindungsvarianten können miteinander kombiniert werden, solange sich die jeweiligen Ausführungsformen nicht gegenseitig ausschließen und die Kombination innerhalb der nachfolgenden Patentansprüche liegt. Die folgenden Beispiele sollen die vorliegende Erfindung verdeutlichen. Sie sind jedoch keinesfalls als limitierend zu betrachten, sondern sollen vielmehr zur Verallgemeinerung anregen. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Prozentangaben sind immer im gegebenen Zusammenhang zu sehen.

### Beispiele

### a) Tb_{1,998}Eu_{0,002}Mo₃O₁₂ (Referenzbeispiel)

1,8684 g (2,498 mmol) Tb₄O₇, 2,1591 g (15,00 mmol) MoO₃ und 0,0018 g (0,0050 mmol) Eu₂O₃ werden in einem Achatmörser unter Zuhilfenahme von Aceton verrieben. Das Pulver wird getrocknet, in einen Porzellantiegel überführt und zweimal bei 900 °C für 10 h an Luft geheizt.

### b) Tb_{1,8}Eu_{0,2}Mo₃O₁₂ (Referenzbeispiel)

1,6832 g (2,250 mmol) Tb₄O₇, 2,1591 g (15,00 mmol) MoO₃ und 0,1760 g (0,5000 mmol) Eu₂O₃ werden in einem Achatmörser unter Zuhilfenahme von Aceton verrieben. Das Pulver wird getrocknet, in einen Porzellantiegel überführt und zweimal bei 900 °C für 10 h an Luft geheizt.

### c) TbEuMo₃O₁₂ (Referenzbeispiel)

0,9351 g (1,250 mmol) Tb₄O₇, 2,1591 g (15,00 mmol) MoO₃ und 0,8800 g (2,500 mmol) Eu₂O₃ werden in einem Achatmörser unter Zuhilfenahme von Aceton verrieben. Das Pulver wird getrocknet, in einen Porzellantiegel überführt und zweimal bei 900 °C für 10 h an Luft geheizt.

### d) Tb_{1,8}Sm_{0,2}Mo₃O₁₂

1,6823 g (2,250 mmol) Tb₄O₇, 2,1591 g (15,00 mmol) MoO₃ und 0,1744 g (0,500 mmol) Sm₂O₃ werden in einem Achatmörser unter Zuhilfenahme von Aceton verrieben. Das Pulver wird getrocknet, in einen Porzellantiegel überführt und zweimal bei 900 °C für 10 h an Luft geheizt.

### e) Tb_{1,2}Eu_{0,8}Mo₃O₁₂ (Referenzbeispiel)

1,1215 g (1,500 mmol) Tb₄O₇, 2,1591 g (15,00 mmol) MoO₃ und 0,7038 g (2,000 mmol) Sm₂O₃ werden in einem Achatmörser unter Zuhilfenahme von Aceton verrieben. Das Pulver wird getrocknet, in einen Porzellantiegel überführt und zweimal bei 900 °C für 10 h an Luft geheizt.

### f) Herstellung einer pc-LED unter Einsatz eines Leuchtstoffs der Zusammensetzung Tb_{1,2}Eu_{0,8}Mo₃O₁₂:

2 g des Leuchtstoffs mit der Zusammensetzung **Tb_{1,2}Eu_{0,8}Mo₃O₁₂** werden abgewogen, mit 8 g eines optisch transparenten Silikons versetzt und anschließend in einem Planeten-Zentrifugalmischer homogen vermischt, so dass die Leuchtstoffkonzentration in der Gesamtmasse 20 Gew.-% beträgt. Das so erhaltene Silikon-Leuchtstoff-Gemisch wird mit Hilfe eines automatischen Dispensers auf den Chip einer near-UV Halbleiter-LED aufgebracht und unter Wärmezufuhr ausgehärtet. Die im vorliegenden Beispiel für die LED-Charakterisierung verwendeten near-UV Halbleiter-LEDs weisen eine Emissionswellenlänge von 395 nm auf und werden mit 350 mA Stromstärke betrieben. Die lichttechnische Charakterisierung der LED erfolgt mit einem Spektrometer der Fa. Instrument Systems - Spektrometer CAS 140 und einer damit verbundenen Integrationskugel ISP 250. Charakterisiert wird die LED über die Ermittlung der wellenlängenabhängigen spektralen Leistungsdichte. Das so erhaltene Spektrum des von der LED emittierten Lichts wird zur Berechnung der Farbpunktkoordinaten CIE x und y verwendet.

### Beschreibung der Figuren

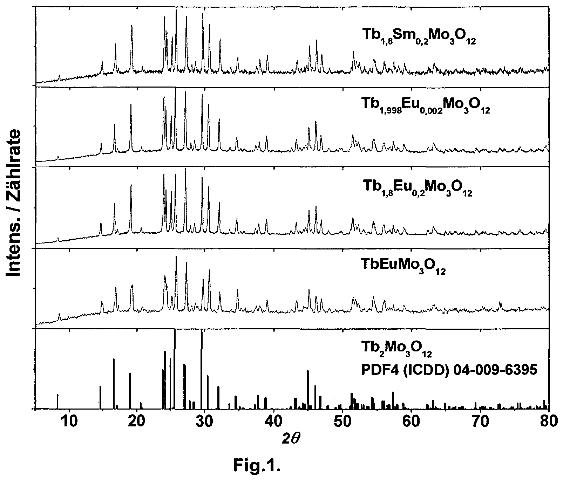

- Fig.1.: Röntgendiffraktogramme von Tb₂₋ₓ*Ln*ₓMo₃O₁₂ für Cu K-alpha-Strahlung

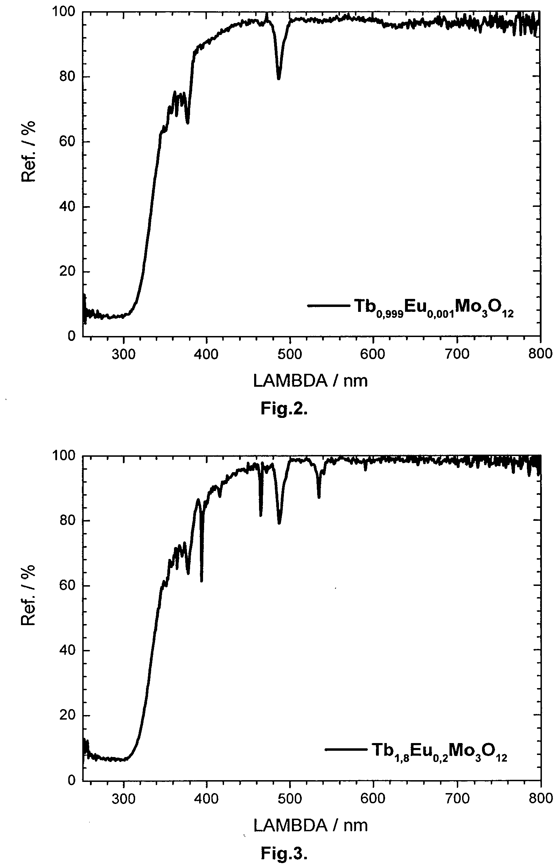

- Fig.2.: Reflexionsspektren von Tb_{1,999}*Eu*_{0,001}Mo₃O₁₂ gegen BaSO₄ als Weißstandard.
- Fig.3.: Reflexionsspektren von Tb_{1,8}E*u*_{0,2}Mo₃O₁₂ gegen BaSO₄ als Weißstandard.

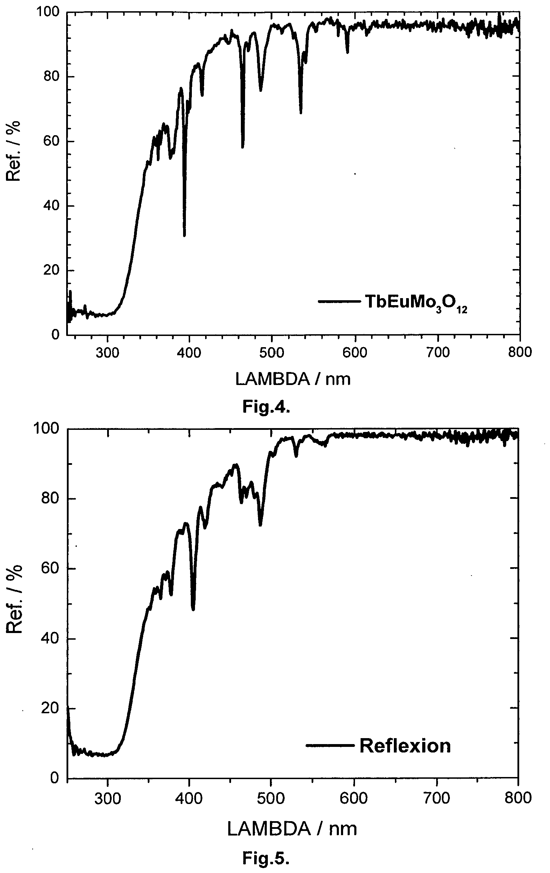

- Fig.4.: Reflexionsspektren von TbEuMo₃O₁₂ gegen BaSO₄ als Weißstandard.
- Fig.5.: Reflexionsspektrum von Tb_{1,8}Sm_{0,2}Mo₃O₁₂ gegen BaSO₄ als Weißstandard.

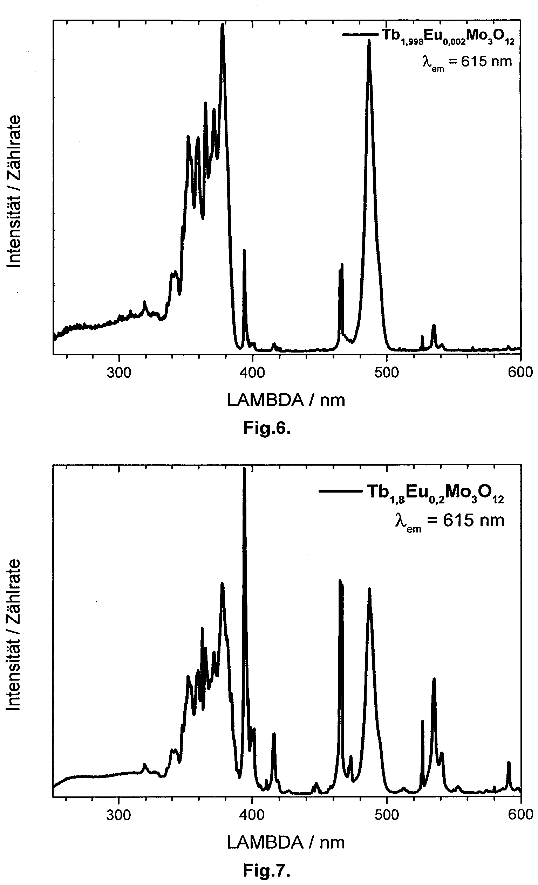

- Fig.6.: Anregungsspektren von Tb_{1,999}*Eu*_{0,001}Mo₃O₁₂ (λₑₘ = 615 nm)
- Fig.7.: Anregungsspektren von Tb_{1,8}E*u*_{0,2}Mo₃O₁₂ (λₑₘ = 615 nm)

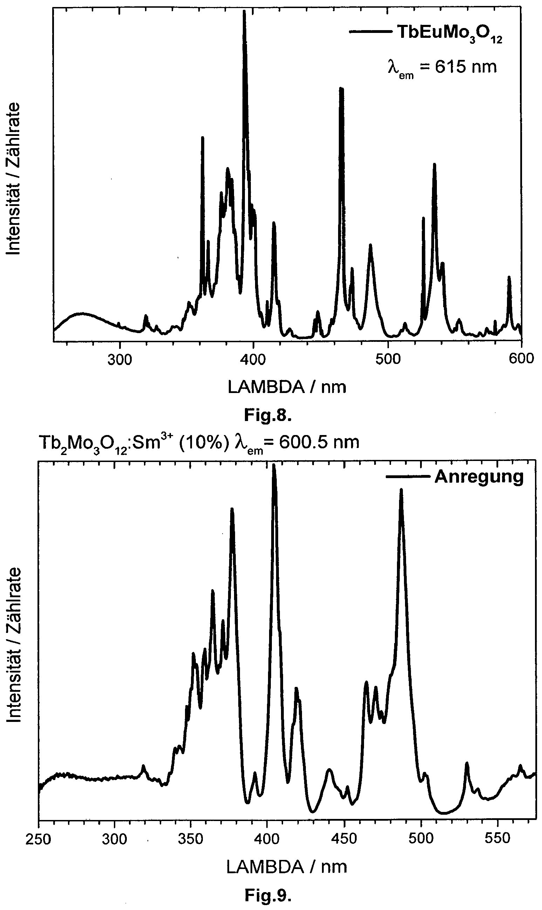

- Fig.8.: Anregungsspektren von TbEuMo₃O₁₂ (λₑₘ = 615 nm)
- Fig.9.: Anregungsspektrum von Tb_{1,8}Sm_{0,2}Mo₃O₁₂ (λₑₘ = 600 nm)

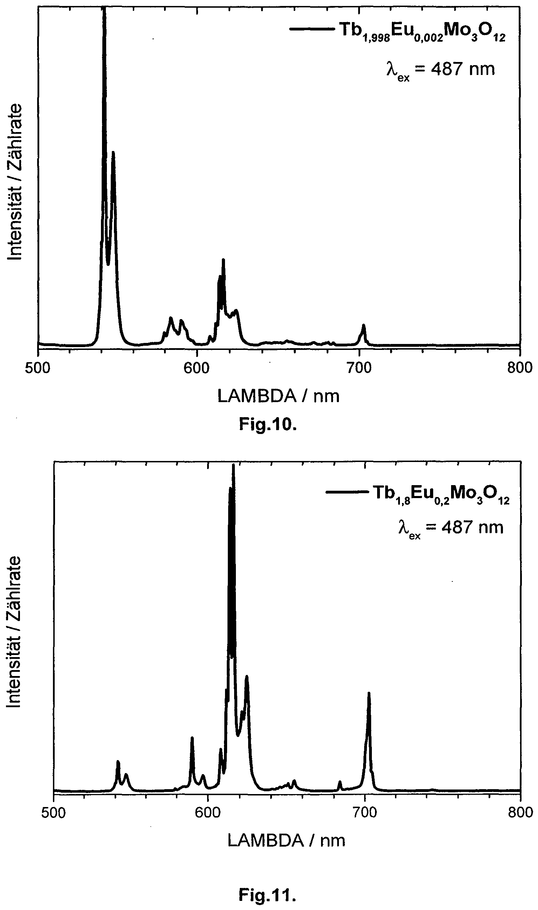

- Fig.10.: Emissionsspektren von Tb_{1,999}*Eu*_{0,001}Mo₃O₁₂ (λₑₓ = 487,0 nm)
- Fig.11.: Emissionsspektren von Tb_{1,8}E*u*_{0,2}Mo₃O₁₂ (λₑₓ = 487,0 nm)

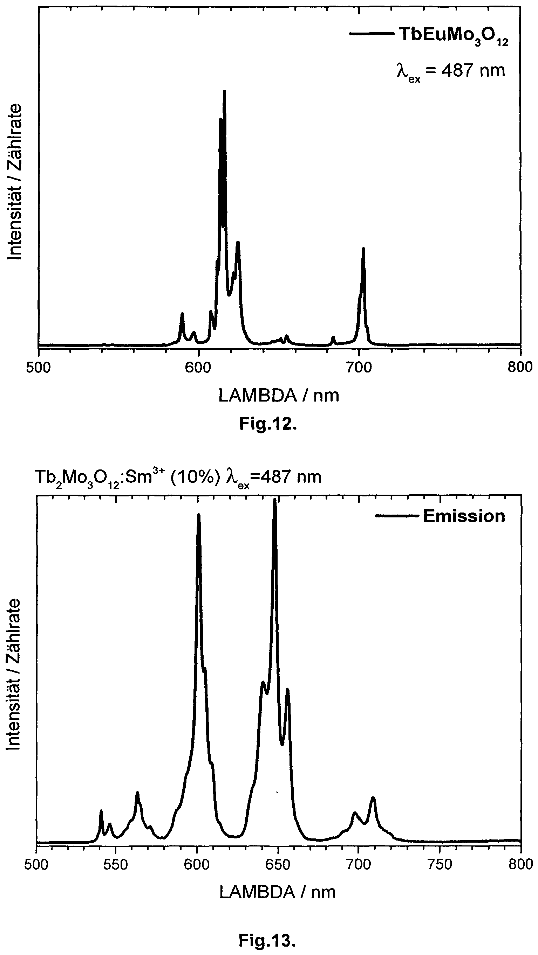

- Fig.12.: Emissionsspektren von TbEuMo₃O₁₂ (λₑₓ = 487,0 nm)
- Fig.13.: Emissionsspektrum von Tb_{1,8}Sm_{0,2}Mo₃O₁₂ (λₑₓ = 487,0 nm)

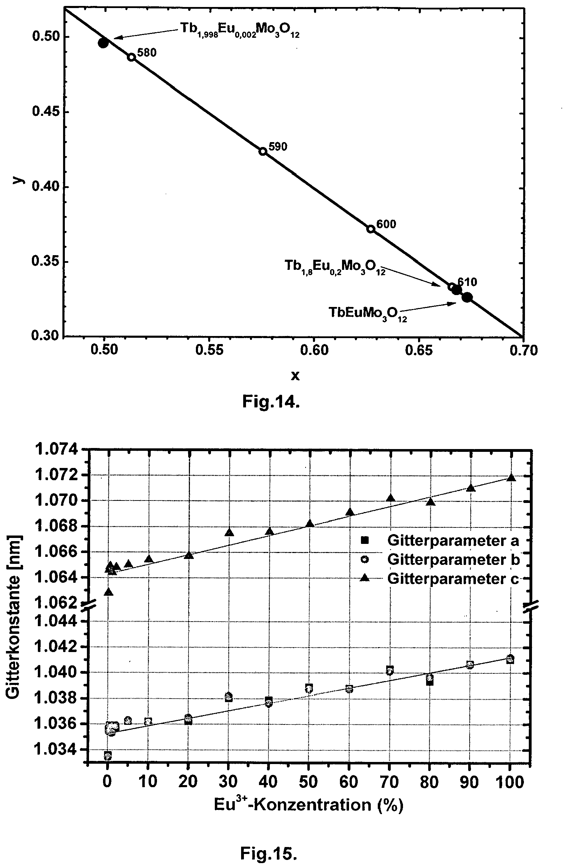

- Fig.14.: Ausschnitt aus dem CIE 1931 Farbdiagramm mit den Farbpunkten von Tb₂₋ₓ*Eu*ₓMo₃O₁₂.
- Fig.15.: Gitterkonstanten der Mischkristallreihe des orthorhombischen Tb₂₋ₓ*Eu*ₓMo₃O₁₂.

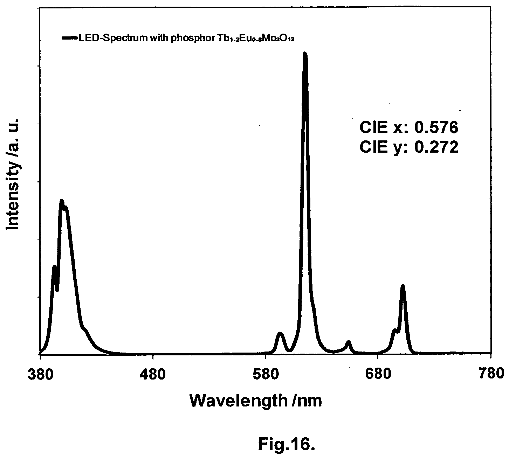

- Fig.16.: LED-Spektrum der in Beispiel f) beschriebenen pc-LED.

## Patentansprüche

1. Verbindung der Formel I,
(Tb₂)ₓ(Mo_{1-b}W_{b})_{y}O_{3x+3y} : Sm³⁺ I
worin
x 1, 2 oder 3;
1 ≤ y ≤ 3; und
0 ≤ b < 1, bedeuten.

2. Verbindung nach Anspruch 1 ausgewählt aus der Formel Ia
(Tb₂₋ₐSm³⁺ₐ)ₓ(Mo_{1-b}W_{b})_{y}O_{3x+3y} Ia
worin x, y und b eine der in Anspruch 1 angegebene Bedeutung haben und 0,1 ≤ a ≤ 1.

3. Verbindungen nach Anspruch 1 oder 2, **dadurch gekennzeichnet, dass** sie phasenrein vorliegen.

4. Verbindungen nach einem oder mehreren der Ansprüche 1 bis 3, worin 0,2 ≤ a ≤ 1.

5. Verbindungen nach einem oder mehreren der Ansprüche 1 bis 4, worin 0,4 ≤ a ≤ 1.

6. Verbindungen nach einem oder mehreren der Ansprüche 1 bis 5, worin x gleich 1 ist.

7. Verbindungen nach einem oder mehreren der Ansprüche 1 bis 6, worin y gleich 3 ist.

8. Verbindungen nach einem oder mehreren der Ansprüche 1 bis 7, worin b gleich 0 ist.

9. Verfahren zur Herstellung einer Verbindung nach einem oder mehreren der Ansprüche 1 bis 8, **dadurch gekennzeichnet, dass** in einem Schritt a) geeignete Edukte ausgewählt aus Nitriden, und Oxiden oder entsprechenden reaktiven Formen einer Samariumquelle, einer Molybdänquelle und einer Terbiumquelle, sowie gegbenenfalls einer Wolframquelle gemischt werden und das Gemisch in einem Schritt b) thermisch behandelt wird.

10. Verwendung einer Verbindung nach einem oder mehreren der Ansprüche 1 bis 8 zur teilweisen oder vollständigen Konversion der blauen oder im nahen UV-liegenden Emission in sichtbares Licht einer höheren Wellenlänge.

11. Emissions-konvertierendes Material umfassend eine Verbindung nach einem oder mehreren der Ansprüche 1 bis 8 und einen oder mehrere weitere Konversionsleuchtstoffe.

12. Lichtquelle mit mindestens einer Primärlichtquelle, **dadurch gekennzeichnet, dass** die Lichtquelle mindestens eine Verbindung gemäß einem oder mehreren der Ansprüche 1 bis 8 oder ein emissionskonvertierendes Material nach Anspruch 11 enthält.

13. Beleuchtungseinheit, insbesondere zur Hintergrundbeleuchtung von Anzeigevorrichtungen, **dadurch gekennzeichnet, dass** sie mindestens eine Lichtquelle nach Anspruch 12 enthält.

14. Anzeigevorrichtung, insbesondere Flüssigkristallanzeigevorrichtung (LC Display), mit einer Hintergrundbeleuchtung, **dadurch gekennzeichnet, dass** sie mindestens eine Beleuchtungseinheit gemäß Anspruch 13 enthält.

## Claims

1. Compound of the formula I,
(Tb₂)ₓ(Mo_{1-b}W_{b})_{y}O_{3x+3y} : Sm³⁺ I
in which
x denotes 1, 2 or 3;
1 ≤ y ≤ 3; and
0 ≤ b < 1.

2. Compound according to Claim 1 selected from the formula Ia
(Tb₂₋ₐSm³⁺ₐ)ₓ(Mo_{1-b}W_{b})_{y}O_{3x+3y} Ia
in which x, y and b have one of the meanings indicated in Claim 1, and 0.1 ≤ a ≤ 1.

3. Compounds according to Claim 1 or 2, **characterised in that** they are in phase-pure form.

4. Compounds according to one or more of Claims 1 to 3, in which 0.2 ≤ a ≤ 1.

5. Compounds according to one or more of Claims 1 to 4, in which 0.4 ≤ a ≤ 1.

6. Compounds according to one or more of Claims 1 to 5, in which x is equal to 1.

7. Compounds according to one or more of Claims 1 to 6, in which y is equal to 3.

8. Compounds according to one or more of Claims 1 to 7, in which b is equal to 0.

9. Process for the preparation of a compound according to one or more of Claims 1 to 8, **characterised in that**, in a step a), suitable starting materials selected from nitrides, and oxides or corresponding reactive forms of a samarium source, a molybdenum source and a terbium source, and optionally a tungsten source, are mixed, and, in a step b), the mixture is thermally treated.

10. Use of a compound according to one or more of Claims 1 to 8 for the partial or complete conversion of the blue or near-UV emission into visible light of a longer wavelength.

11. Emission-converting material comprising a compound according to one or more of Claims 1 to 8 and one or more further conversion phosphors.

12. Light source having at least one primary light source, **characterised in that** the light source comprises at least one compound according to one or more of Claims 1 to 8 or an emission-converting material according to Claim 11.

13. Lighting unit, in particular for the backlighting of display devices, **characterised in that** it contains at least one light source according to Claim 12.

14. Display device, in particular liquid-crystal display device (LC display), having backlighting, **characterised in that** it contains at least one lighting unit according to Claim 13.

## Revendications

1. Composé de la formule I :
(Tb₂)ₓ(Mo_{1-b}W_{b})_{y}O_{3x+3y} : Sm³⁺ I
dans laquelle :
x représente 1, 2 ou 3 ;
1 ≤ y ≤ 3 ; et
0 ≤ b < 1.

2. Composé selon la revendication 1 sélectionné parmi la formule la :
(Tb₂₋ₐSm³⁺ₐ)ₓ(MO_{1-b}W_{b})_{y}O_{3x+3y} Ia
dans laquelle x, y et b présentent l'une des significations qui sont indiquées selon la revendication 1, et 0,1 ≤ a ≤ 1.

3. Composés selon la revendication 1 ou 2, **caractérisés en ce qu'**ils sont selon une forme à phase pure.

4. Composés selon une ou plusieurs des revendications 1 à 3, dans lesquels 0,2 ≤ a ≤ 1.

5. Composés selon une ou plusieurs des revendications 1 à 4, dans lesquels 0,4 ≤ a ≤ 1.

6. Composés selon une ou plusieurs des revendications 1 à 5, dans lesquels x est égal à 1.

7. Composés selon une ou plusieurs des revendications 1 à 6, dans lesquels y est égal à 3.

8. Composés selon une ou plusieurs des revendications 1 à 7, dans lesquels b est égal à 0.

9. Procédé pour la préparation d'un composé selon une ou plusieurs des revendications 1 à 8, **caractérisé en ce que**, au niveau d'une étape a), des matériaux de départ appropriés qui sont sélectionnés parmi les nitrures et les oxydes ou des formes réactives correspondantes d'une source de samarium, d'une source de molybdène et d'une source de terbium, et en option d'une source de tungstène, sont mélangés, et, au niveau d'une étape b), le mélange est traité thermiquement.

10. Utilisation d'un composé selon une ou plusieurs des revendications 1 à 8 pour la conversion partielle ou complète de l'émission de bleu ou des UV proches selon une lumière visible d'une longueur d'onde plus longue.

11. Matériau de conversion d'émission comprenant un composé selon une ou plusieurs des revendications 1 à 8 et un ou plusieurs autre(s) phosphore(s) de conversion.

12. Source de lumière comportant au moins une source de lumière primaire, **caractérisée en ce que** la source de lumière comprend au moins un composé selon une ou plusieurs des revendications 1 à 8 ou un matériau de conversion d'émission selon la revendication 11.

13. Unité d'éclairage, en particulier pour l'éclairage arrière de dispositifs d'affichage, **caractérisée en ce qu'**elle contient au moins une source de lumière selon la revendication 12.

14. Dispositif d'affichage, en particulier dispositif d'affichage à cristaux liquides (affichage LC), comportant un éclairage arrière, **caractérisé en ce qu'**il contient au moins une unité d'éclairage selon la revendication 13.
